# EUROPÄISCHE PATENTSCHRIFT

(11) **EP 0 652 639 B1**
(45) Veröffentlichungstag und Bekanntmachung des Hinweises auf die Patenterteilung: **20.12.2000**
(21) Anmeldenummer: 94117202.5
(22) Anmeldetag: 31.10.1994
(51) Int. Cl.: H03K 17/08, H03K 17/082, H03K 17/691

(54) **Treiberschaltung**
Driver circuit
Circuit d'attaque

(30) Priorität: 08.11.1993 DE 4338083
(43) Veröffentlichungstag der Anmeldung: 10.05.1995
(73) Patentinhaber: GRÜNDL UND HOFFMANN GmbH GESELLSCHAFT FÜR ELEKTROTECHNISCHE ENTWICKLUNGEN, 82319 Starnberg (DE)
(72) Erfinder: Hösl, Werner, D-92507 Nabburg (DE); Gründl, Andreas, Dr., D-81377 München (DE); Hoffmann, Bernhard, D-82319 Starnberg (DE)
(74) Vertreter: Schmidt, Steffen J., Dipl.-Ing.

(56) Entgegenhaltungen:
- DE-A- 4 007 539
- US-A- 5 206 540
- ELEKTROTECHNIK UND INFORMATIONSTECHNIK, Bd. 109, Nr. 6, 1.Januar 1992 Seiten 314-317, XP 000304937 KRISCHAN K 'KONSTRUKTION UND BETRIEB EINES IGBT-PULSWECHSELRICHTERS'
- PATENT ABSTRACTS OF JAPAN vol. 6 no. 205 (E-136) [1083] ,16.Oktober 1982 & JP-A-57 113606 (SHIYOUEI DENKI K.K.) 15.Juli 1982,
- FUNK-TECHNIK, Bd. 41, Nr. 11, November 1986 HEIDELBERG, DE, Seiten 465-467, HALL 'Parallelschaltung von Leistungs-MOSFET'
- FIFTH EUROPEAN CONFERENCE ON POWER ELECTRONICS AND APPLICATIONS, Bd. 2, 13. - 16.September 1993 BRIGHTON, GB, Seiten 191-196, XP 000416037 OCHI ET AL. 'I3M (TM), an Intelligent, Isolated, Integrated Half-Bridge Power Module'
- ELEKTRIE, Bd. 44, Nr. 10, 1.Januar 1990 Seiten 365-367, XP 000176858 CONRAD H 'SMART POWER DEVICES-ERGEBNIS DER INTEGRATION BEI LEISTUNGSELEKTRONISCHEN BAUELEMENTEN'

## Beschreibung

Die vorliegende Erfindung betrifft eine Treiberschaltung für eine Leistungsendstufe, mit den Merkmalen des Oberbegriffs des Anspruchs 1, wie sie aus der DE 40 07 539 A1 bekannt ist. Als Leistungsendstufen werden dabei entweder Leistungs-MOSFET mit hoher Ansteuertaktfrequenz oder Leistungs-IGBT verwendet, die im Schaltbetrieb arbeiten, um hohe Leistungen schnell und verlustarm zu schalten. Derartige Treiberschaltungen sind in der betrieblichen Praxis vielfach bekannt und eingesetzt. Grundsätzlich kann die vorliegende Erfindung für alle Arten von Leistungsendstufen verwendet werden, die einen FET-Eingang haben.

Aus Elektrotechnik und Informationstechnik, Band 109, Nr. 6, 1. Januar 1992, S.314 bis 317, K. Krischan: "Konstruktion und Betrieb eines IGBT-Pulswechselrichters" ist ein dreiphasiger Pulswechselrichter bekannt, der eine Ansteuerschaltung aufweist, in der die vom Pulsweitenmodulator kommenden Pulse potential-getrennt übertragen und in zur Ansteuerung der Leistungshalbleiter geeignete Signale umgewandelt werden. Außerdem ist in der Ansteuerschaltung eine Überstromabschaltung vorgesehen. Die potential-getrennte Übertragung der Impulse des Pulsweitenmodulators erfolgt mittels induktiver Koppler.

Das Problem bei herkömmlichen Treiberschaltungen besteht darin, daß die Laufzeiten zwischen dem Eingangsanschluß der Treiberschaltung und deren Ausgangsanschluß relativ lang sind, die Reaktionszeiten im Störfall relativ hoch sind, die Mindest-Ein-Blockierzeiten sich nicht kurz genug einstellen lassen, und die Taktfrequenz-Tastgradbereiche nach oben stark begrenzt sind.

Aus der DE 36 114 832 C2 ist eine galvanisch trennende Signalübertragungsschaltung bekannt, die aus digitalen Eingangssignalen über eine Eingangsspule und eine dazu in Abstand angeordnete beschaltete Ausgangsspule galvanisch getrennte Ausgangssignale erzeugt. Dazu sind die Spulen so beabstandet, daß praktisch rückwirkungsfreie Ausgangssi-gnale an den Klemmen der Ausgangsspule bereitstehen. Diese Schaltung soll eine hinreichende Spannungsfestigkeit mit einem geringen Beschaltungsaufwand erzielen.

Aus der DE 29 12 693 A1 ist ein Trennverstärker bekannt, der einen Transformator zur Potentialtrennung von Impulsen verwendet. Dieser Trennverstärker ist so gestaltet, daß er sehr genau arbeitet, indem Versorgungsströme und Signalströme getrennt werden.

Aus der DE 21 03 091 A1 ist ein Transistor-Zerhacker-Modulator bekannt, der einen Transformator aufweist, bei dem zum Zwecke der Minimierung von Störungen eine geerdete Abschirmung zwischen den nebeneinander auf den Transformatorkern gewickelten Primär- und Sekundärwicklung angebracht ist. Bei diesem Modulator soll sichergestellt werden, daß keine Störsignale auftreten.

Aus der DE 25 25 741 B2 ist ein Taktimpulssystem mit einem sehr komplex aufgebauten Transformator bekannt, bei dem die Primär- und Sekundärwicklungen bifilar in einander verwunden auf den Kern des Transformators gewickelt sind. Durch die dort beschriebene Anordnung wird erreicht, daß zwei zueinander symmetrische und zeitlich versetzte Impulssignale gleichstromanteilfrei erzeugt und verteilt werden können.

Aus Patent Abstracts of Japan, Sect. E, Vol. 2 (1978), Nr. 145 (E-75) zu JP 53-112048 A2 ist ein Signalisolationsschaltkreis bekannt, der ein störungsfreies Analog-Ausgangssignal liefert, indem ein Transformator mit wenigstens zwei oder mehr Wicklungen und ein Abtast-Haltekreis mit einem gesättigten Kern vorgesehen ist.

Aus Patent Abstracts of Japan, Sect. E, Vol. 6 (1982), Nr. 205 (E-136) zu JP 57-113606 A ist ein Isolationsverstärkungsschaltkreis bekannt, der zur Signalübertragung für eine Steuereinrichtung verwendet wird. Dabei wird die Abtastperiode und die Phase so eingestellt, daß der Erregungsstrom null ist. Dies ermöglicht die Verwendung eines Transformators und einer einfachen Beschaltung bei hoher Genauigkeit.

Aus Patent Abstracts of Japan, Sect. E, Vol. 12 (1988), Nr. 124 (E-601) zu JP 62-25 07 04 A ist ein isolierter Spannungsdetektor bekannt, der dazu dient, die Anzahl der notwendigen Teile zu reduzieren und gleichzeitig die Zuverlässigkeit der Schaltung dadurch zu erhöhen, daß das Ausgangssignal eines Inverters direkt als das Ansteuersignal eines isolierenden Verstärkers verwendet wird.

Die der Erfindung zugrunde liegende Aufgabe ist dementsprechend eine Treiberschaltung bereitzustellen, die kurze Signal-Laufzeiten ermöglicht, kleinbauend ist, eine große Signal-Taktfrequenzbandbreite hat und die eine erhöhte Betriebssicherheit gewährleistet.

Diese Aufgabe wird durch eine eingangs genannte Treiberschaltung gelöst, die durch die Merkmale des kennzeichnenden Teils des Anspruchs 1 weitergebildet ist.

Durch die im Oberbegriff genannte Überstromerkennungsstufe, die eine Ansteuerung der Leistungstreiberstufe verhindert, wenn die Drain-Source- (bei MOSFET Endstufe) bzw. die Kollektorspannung (bei IGBT-Endstufe) der Leistungsendstufe einen vorbestimmten Wert überschreitet, wird sichergestellt, daß die Leistungsendstufe nicht überlastet werden kann, so daß ein Ausfallen der Leistungsendstufe wirksam verhindert ist.

Weiteres Merkmal der Treiberschaltung ist eine Wiederhol-Impulsunterdrückungsstufe, die eine Aufhebung des durch das Sperrsignal der Überstromerkennungsstufe hervorgerufenen Unwirksamschaltens der Eingangsstufe verhindert.

Dadurch ist es möglich, die Leistungstransistoren der Leistungsendstufe abzuschalten und für einen vorbestimmten Zeitraum am Wiedereinschalten zu hindern. Dies bewirkt eine thermische Überlastsicherung im Kurzschlußfall. Wegen der hohen Reaktionsgeschwindigkeit der Überstromerkennungsstufe im Kurzschlußfall kann auf die herkömmlichen di/dt-Begrenzungsdrosseln verzichtet werden.

Erfindungsgemäß ist der einzige Signaleingang der Wiederhol-Impulsunterdrückungsstufe leitend mit dem Ausgang der Überstromerkennungsstufe verbunden.

Da die Unterspannungserkennungsstufe eine Ansteuerung der Leistungstreiberstufe verhindert, wenn eine von der Stromversorgungsstufe abgegebene Betriebsspannung einen vorbestimmten Wert unterschreitet, kann sichergestellt werden, daß die Ansteuersignale für die Leistungsendstufe stets so dimensioniert sind, daß diese nicht in den linearen Arbeitsbereich gerät.

Vorteilhaft weist die Eingangsstufe einen hochfrequenzsignalübertragenden Transformator für die Einspeisung von Ansteuersignalen auf. Damit ist eine Ansteuerung mit einer Untergrenze im Gleichspannungssignalbreich und einer Obergrenze im MHz-Bereich möglich. Außerdem erlaubt ein derartiger Transformator Tastverhältnisse des Eingangssignals von 0% - 100 % zu übertragen.

Um eine Einkopplung von Störungen bei schnell schaltenden Leistungsbauteilen zu vermeiden, weist der Transformator bevorzugt eine primärseitige und/oder eine sekundärseitige Abschirmung auf. Dieser abgeschirmte Transformator kann insbesondere durch einen Ringkern mit einer aufgebrachten entlang des Umfangs geschlitzten Metallschicht gebildet sein.

Um bei möglichst geringem Bauvolumen des Ansteuertransformators Ansteuersignale ohne Laufzeitverlust bereitstellen zu können, weist bei der erfindungsgemäßen Treiberschaltung die Ansteuerschaltung ein Speicherelement zur Speicherung der Ansteuersignale auf. Das Speicherelement ist vorzugsweise ein aus zwei Invertern gebildetes Flip-Flop, das pegelgesteuert arbeitet.

Bei einer bevorzugten Ausführungsform weist die Stromversorgungsstufe einen Transformator für die Übertragung von elektrischer Leistung auf, der mit hochfrequenter elektrischer Leistung speisbar ist. Durch die Speisung mit einer hochfrequenten hochfrequenten Leistung kann ein sehr kleiner Transformator verwendet werden und gleichzeitig eine ausreichende Leistung für die Spannungsversorgung der Treiberschaltung zur Verfügung gestellt werden.

Insbesondere gilt dies, wenn der Transformator ein elektrisches Leistungssignal mit einer Frequenz im Bereich von 0,5 MHz bis 5 MHz, vorzugsweise 1,5 MHz überträgt.

Das entsprechende elektrische Leistungssignal ist vorzugsweise ein Rechteck-Impulszug, der von einer durch einen Oszillator gespeisten Verstärkerstufe dem Transformator zugeführt ist.

Um eine möglichst rückwirkungsfreie und störungsarme Stromversorgung zu haben, weist der Transformator vorzugsweise eine primärseitige und/oder eine sekundärseitige Abschirmung auf. Außerdem bewirkt ein derartig gestalteter Transformator bei der vorliegenden Treiberschaltung, daß keine Störsignale, hervorgerufen durch Ansteuersignale, in angrenzende Schaltkreise dringen. Der Transformator kann im Prinzip den gleichen Aufbau haben wie der Transformator für die Eingangsstufe.

Um einen möglichst störungsfreien Betrieb (bei höheren Temperaturen) der Leistungsendstufe zu erreichen ist es vorteilhaft, wenn die Ansteuersignale zwischen einem positiven und einem negativen Pegel hin und her gehen können. Dazu ist es erforderlich, daß die Stromversorgungsstufe eine positive und eine negative Betriebsspannung bereitstellt. Dennoch kann die erfindungsgemäße Treiberschaltung z.B. an einer einfachen 12V-Stromquelle betrieben werden, da alle erforderlichen Betriebsspannungspegel durch die spezielle Stromversorgungsstufe daraus erzeugt werden. Dies ist insbesondere für mobile Einsatzzwecke (strombetriebene KFZ oder dergl.) vorteilhaft.

Vorzugsweise weist die Unterspannungserkennungsstufe einen Komparator auf, der eine einstellbare Hysteresekurve hat. Damit kann in weiten Grenzen die Betriebssicherheit der Gesamtanordnung (Treiberschaltung mit Leistungsendstufe) festgelegt werden.

Insbesondere ist der Komparator aus zwei in Reihe geschalteten rückgekoppelten Invertern gebildet, an deren Eingang eine Z-Diode vorbestimmter Durchbruchsspannung angekoppelt ist.

Bei einem Komparator dieser Bauart (mit CMOS-Invertern) liegt die Besonderheit darin, daß bei einer Annäherung an den Schaltpunkt die Inverter nicht im Schaltbetrieb, sondern im linearen Betrieb sind. Dadurch steigt der Stromverbrauch stark an (ca. 35 mA). Beim Hochfahren der Betriebsspannung wird die Stromversorgung im Umschaltpunkt zusätzlich belastet. Kann die Betriebsspannung gegen diese Last weiter ansteigen, so kippt der Komparator. Dadurch werden die Ansteuersignale freigegeben. Gleichzeitig sinkt der Stromverbrauch des Komparators wieder auf ca. 1mA ab. Im Störfall wird die zusätzlich gesteigerte Stromaufnahme der Schaltung dazu beitragen, daß die Spannung weiter abfällt, und somit der Umschaltpunkt noch schneller bzw. noch sicherer erreicht wird. Wenn der Umschaltpunkt durchschritten ist, geht die Stromaufnahme wieder auf den Normalwert (ca. 1mA für IC4) zurück.

Bei einer bevorzugten Ausführungsform gibt die Unterspannungserkennungsstufe ein Signal zum Unwirksamschalten der Ansteuerschaltung ab, wenn eine von der Stromversorgungsstufe abgegebenen Betriebsspannungen einen vorbestimmten Wert unterschreitet.

Die Überstromerkennungsstufe weist bevorzugt einen Inverter auf, der ein Sperrsignal zum Unwirksamschalten der Ansteuerschaltung abgibt, wenn die Drain-Source - bzw. die Kollektorspannung der Leistungsendstufe einen vorbestimmten Wert überschreitet.

Insbesondere gibt dabei der Inverter ein Sperrsignal an das Speicherelement der Eingangsstufe ab.

Um eine Ansprechverzögerung der Überstromerkennungsstufe beim Einschalten zu bewirken, die so bemessen ist, daß die Leistungsendstufe vollständig durchschalten kann, weist der Inverter der Überstromerkennungsstufe an seinem Eingang ein RC-Netzwerk auf.

Vorzugsweise ist das RC-Netzwerk so bemessen, daß nach dem Einschalten die Überstromerkennungsstufe erst nach einer Ansprechverzögerung von weniger als 100 ns ein Sperrsignal abgeben kann.

Vorzugsweise werden für die Wiederholungs-Impulsunterdrückung zwei hintereinandergeschaltete CMOS-Monoflops verwendet, so daß eine Doppelimpulsunterdrückung erzielt wird, die Blockierzeiten im Sekundenbereich bewirkt.

Wenn als Leistungsendstufe eine MOSFET-Endstufe verwendet wird, weist die Leistungstreiberstufe vorzugsweise mehrere parallelgeschaltete Inverter auf, deren Ausgänge mit zwei Treibertransistoren verbunden sind, die die zur Ansteuerung des Eingangsanschlusses der Leistungsendstufe erforderlichen Signale bereitstellen.

Die vorliegende Erfindung kann sowohl für Leistungsendstufen mit Leistungs-MOSFET als auch mit Leistungs-IGBT eingesetzt werden, lediglich die die Leistungsendstufe ansteuernde Leistungstreiberstufe muß entsprechend angepaßt werden. Die Unterschiede zwischen MOSFET und IGBT bestehen hauptsächlich darin, daß IGBT's im Gegensatz zu MOSFET's nicht parallelschaltbar sind. Außerdem haben IGBT's keinen temperaturabhängigen Durchlaßwiderstand und benötigen höhere Gate-Spannungen bei gleichzeitig sehr viel höheren Eingangskapazitäten.

Wenn als Leistungsendstufe eine IGBT-Endstufe verwendet wird, weist die Leistungstreiberstufe eine Pegelumsetzerstufe und wenigstens zwei separate Inverter-IC's auf, die auf unterschiedlichem Betriebsspannungsniveau arbeiten, deren Ausgänge mit einer Treibertransistorstufe verbunden ist, die die zur Ansteuerung des Eingangsanschlusses der Leistungsendstufe erforderlichen Signale bereitstellt.

Bevorzugt weist dabei die Treibertransistorstufe eine aus einem P-Kanal-MOSFET und einem N-Kanal-MOSFET gebildete Halbbrücke auf, und die Leistungstreiberstufe weist wenigstens ein Totzeitglied (von etwa 20 ns) für das Ansteuersignal auf. Dadurch kann ein Brückenquerschluß der MOSFET-Halbbrücke vermieden werden.

Diese MOSFET-Halbbrücke steuert zwei komplementäre bipolare in Emitterfolgerschaltung im B-Betrieb geschaltete PNP- bzw. NPN-Leistungstransistoren an, die das Ansteuersignal für die IGBT-Leistungsendstufe liefern.

Eine derartige Leistungstreiberstufe arbeitet sehr verlustarm und stellt sicher, daß bei kapazitiver Belastung Ausgangsströme von bis zu +/- 12 A und Gate-Spannungen bis zu +/- 20 V als Eingangssignal für die Leistungsendstufe bereitgestellt werden können.

Durch die erfindungsgemäße Treiberschaltung werden insgesamt die folgenden Vorteile und Eigenschaften erzielt.

Das Bauvolumen und die Herstellungskosten sind gering. Alle Inverter können CMOS-Inverter mit geringer Leistungsaufnahme sein. Die Laufzeiten vom Eingangssignalanschluß zum Ansteueranschluß der Leistungsendstufe sind extrem kurz (im Bereich von 100 ns für MOSFET-Endstufen und ca. 150 ns - 180 ns für IGBT-Endstufen). Bei den MOSFET-Endstufen können ohne weiteres mehrere gleichartige Endstufen parallel angesteuert werden. Die Laufzeitunterschiede mehrerer parallel betriebener erfindungsgemäße Treiberschaltungen sind ebenfalls sehr gering. Sie liegen im Bereich von ca 13 ns. Das bedeutet, daß komplette Leistungsschaltbaugruppen (Treiberschaltung mit Leistungsendstufe) durch sehr kleine Ausgangsdrosseln parallel geschaltet werden können. Die Leistungs-Endstufen werden auch bei nicht anliegender Versorgungsspannung sehr niederohmig angesteuert, so daß die Einschalt- bzw. Ausschaltreihenfolge der Treiberschaltung und der Leistungsendstufe beliebig sein kann. Die Spannungsschwankungs-Verträglichkeit (du/dt-Verträglichkeit) ist sehr hoch.

Bei einer für IGBT-Endstufen ausgelegten Treiberschaltung gemäß der Erfindung ergeben sich die Vorteile, daß sehr große IGBT-Leistungsendstufen mit Eingangskapazitäten von mehr als 100 nF bei Taktfrequenzen von mehr als 50 kHz betrieben werden können. Dabei beträgt die Spannungssteilheit am Ansteueranschluß der IGBT-Endstufe 100 V/µs bei einer Lastvon 100nF/1Ohm.

Da IGBT sehr viel langsamer schalten als MOSFET, haben die zusätzlichen Laufzeiten und die Totzeiten keinen negativen Einfluß.

Weitere Eigenschaften und Vorteile der Erfindung werden durch die Beschreibung zweier Ausführungsformen anhand der beigefügten Zeichnungen deutlich, wobei
- Fig. 1: ein Blockschaltbild einer Treiberschaltung für eine MOSFET-Leistungsendstufe zeigt;
- Fig. 2: ein elektrisches Schaltbild der Treiberschal tung für eine MOSFET-Leistungsendstufe nach Fig. 1 zeigt;
- Fig. 3: ein Blockschaltbild einer Treiberschaltung für eine IGBT-Leistungsendstufe zeigt;
- Fig. 4: ein elektrisches Schaltbild der Treiberschal tung für eine IGBT-Leistungsendstufe nach Fig. 3 zeigt;
- Fig. 5: ein elektrisches Schaltbild des Transformators für die Eingangsstufe zeigt;
- Fig. 6: der Transformator für die Eingangsstufe nach Fig. 5 in schematischer Draufsicht zeigt;
- Fig. 7: ein elektrisches Schaltbild des Transformators für die stromversorgungsstufe ist; und
- Fig. 8: der Transformator für die Stromversorgungsstufe nach Fig. 7 in schematischer Draufsicht zeigt.

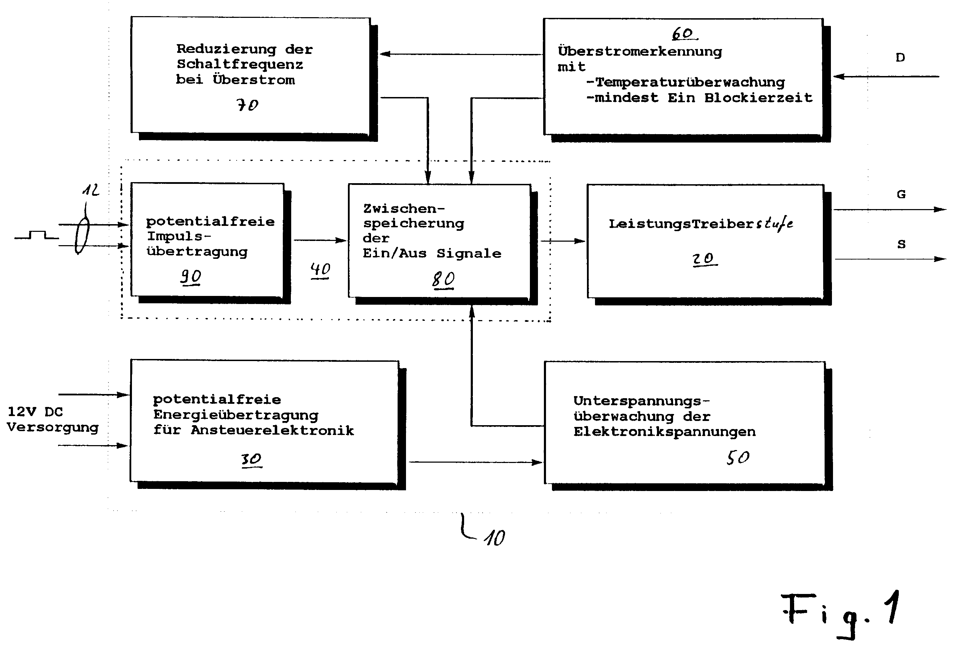

Fig. 1 stellt ein Blockschaltbild einer Treiberschaltung für eine (nicht gezeigte) MOSFET-Leistungsendstufe dar, wie sie z.B. in der vorangemeldeten DE 42 30 510.1 beschrieben ist.

Die Treiberschaltung 10 weist folgende Baugruppen auf: Eine Leistungstreiberstufe 20, eine Stromversorgung 30, eine die Leistungstreiberstufe 20 ansteuernde Ansteuerschaltung 40, eine Unterspannungserkennungsstufe 50, eine Überstromerkennungsstufe 60, und eine Wiederhol-Impulsunterdrückungsstufe 70.

Die Ansteuerschaltung 40 weist eine Eingangsstufe 90 und eine Speicherstufe 80 auf.

Der Treiberschaltung werden über Eingangsanschlüsse 12 digitale Steuersignale zugeführt, deren Frequenz als Untergrenze praktisch im Gleichspannungssignalbereich liegt, und deren Obergrenze im 1 - 2 MHz-Bereich liegt. Die Tastverhältnisse des Eingangssignals können zwischen 0% und 100 % liegen.

Die Stromversorgung 30 wird von einer einfachen +12V Gleichspannungsquelle gespeist, wobei die Stromversorgung 30 für den Betrieb der Treiberschaltung 10 erforderliche positive und negative Spannungen aus der 12V Gleichspannung erzeugt.

Die Leistungstreiberstufe 20 weist einen Gate-Anschluß G und einen Emitteranschluß E für die Leistungsendstufe auf. Außerdem weist die Überstromerkennungsstufe 60 einen Drainanschluß D auf, der ebenfalls mit der Leistungsendstufe zu verbinden ist.

Die Leistungstreiberstufe 20 wird von der Speicherstufe 80 der Ansteuerstufe 40 angesteuert. Dabei erfolgt die Weiterleitung der Ansteuersignale durch die aus der Speicherstufe 80 heraus nur dann, wenn 1. die Überstromerkennungsstufe 60 kein Sperrsignal an die Speicherstufe 80 abgibt, weil die Leistungsendstufe zuviel Drainstrom aufnimmt, 2. die Unterspannungserkennungsstufe 50 kein Sperrsignal an die Speicherstufe 80 abgibt, weil wenigstens eine der Betriebsspannungen der Stromversorgungen unter einen vorbestimmten Pegel gefallen ist, und 3. ein von der Überstromerkennungsstufe 80 erkannter Überstromfall schon so lange her ist, daß eine in der WiederholImpulsunterdrückungsstufe 70 vorbestimmte Zeit abgelaufen ist.

Die Speicherstufe 80 wird von der Eingangsstufe 90 mit Eingangssignalen gespeist, wobei die Ausgangssignale der Eingangsstufe 90 gegen die Eingangssignale potentialgetrennt sind, d.h. Eingangssignale und Ausgangssignale der Eingangsstufe 90 haben kein gemeinsames Bezugspotential.

Entsprechendes gilt für die von der Stomversorgung 30 erzeugten Betriebsspannungen. Die Stomversorgung 30 erzeugt zum Betrieb der einzelnen Baugruppen sowohl positive als auch eine negative Betriebsspannungen (+15V, +20V, -20V für IGBT und +12V, -5V für MOSFET). Auch diese Betriebsspannungen haben mit der äußeren +12V Versorgungsspannung kein gemeinsames Bezugspotential.

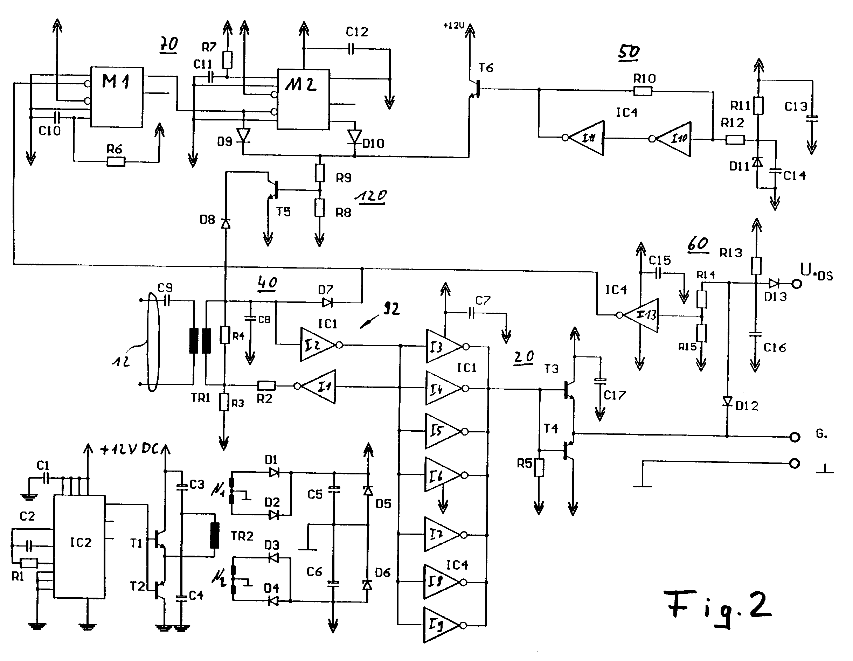

In Fig. 2 ist die Treiberschaltung 10 von Fig. 1 in ihren Schaltungsdetails dargestellt. Dabei werden integrierte CMOS-Bausteine (Inverter, Treiber, Oszillator, Monoflops) verwendet.

Die Stromversorgungsstufe 30 ist durch einen Oszillator IC2 gebildet, dessen Taktfrequenz durch einen Widerstand R1 und einen Kondensator C2 auf eine Frequenz im Bereich von 0,5 MHz bis 5 MHz, vorzugsweise 1,5 MHz festgelegt ist. Der Oszillator IC2 liefert einen Rechteck-Impulszug, der zur Ansteuerung einer aus zwei Treibertransistoren T1, T2 gebildeten Verstärkerstufe dient, die als komplementärer Emitterfolger verschaltet ist.

Die jeweiligen Kollektoranschlüsse der Transistoren T1, T2 sind mit der 12V-Gleichspannungsquelle (Pluspol und Masse) verbunden und mit einer Serienschaltung aus zwei Elektrolytkondensatoren C3, C4 parallel verschaltet. Zwischen dem Verbindungspunkt der beiden Elektrolytkondensatoren C3, C4 und der Verbindung der Emitter der beiden Treibertransistoren T1, T2 liegt die Primärwicklung eines Transformators TR2. Der Transformator TR2 ist ein FerritRingkerntrafo, der eine primärseitige und eine sekundärseitige Abschirmung aufweist. Die Abschirmung erfolgt durch eine metallische, mit der Betriebsspannungsmasse verbundene Ummantelung des Ringkerns, die als radial geschlitzter Torusabschnitt unter den jeweiligen Spulenwicklungen ausgestaltet ist.

Sekundärseitig hat der Transformator TR2 zwei Wicklungen N1, N2 mit Mittelabgriff, die jeweils mit zwei Dioden D1, D2; D3, D4 in Mittelpunkt-Gleichrichterschaltung verbunden sind. Die Ausgänge sind jeweils mit zwei Elektrolytkondensatoren C5, C6 zur Glättung verschaltet, denen jeweils eine Zener-Diode D5, D6 parallelgeschaltet ist.

Begrenzt durch die Durchbruchsspannung der Zener-Dioden D5, D6 stellt die Stromversorgungsstufe 30 jeweils eine positive und eine negative konstantgehaltene Betriebsspannung (+12V, -5V) bereit.

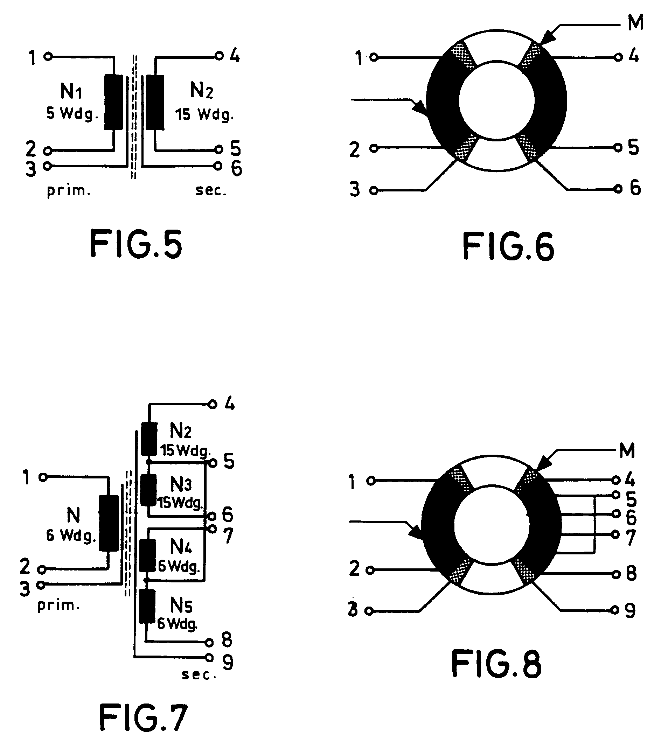

Die Eingangsstufe 90 weist einen Transformator TR1 auf, an dessen einem primärseitigen Anschluß ein Trennkondensator C9 angeschlossen ist. der andere primärseitige Anschluß des Transformators TR1 und der andere Anschluß des Trennkondensators C9 bilden die Eingangsanschlüsse 12 der Treiberschaltung 10. Der Transformator TR1 (für nähere Einzelheiten siehe Fig. 5, 6) ist ebenfalls ein Ferrit-Ringkerntrafo, der eine primärseitige und eine sekundärseitige Abschirmung aufweist. Die Abschirmung erfolgt durch eine metallische, mit der Betriebsspannungsmasse verbundene Ummantelung des Ferritkerns, die als radial geschlitzter Torusabschnitt unter den jeweiligen Spulenwicklungen ausgeformt ist.

Sekundärseitig weist der Transformator TR1 einen Parallelwiderstand R4 auf. Über einen Widerstand R3 ist der eine Anschluß und über einen Kondensator C8 ist der andere Anschluß der Sekundärseite des Transformators TR1 mit der negativen Betriebsspannung verbunden. Der über den Widerstand R3 mit der negativen Betriebsspannung verbundene Anschluß der Sekundärseite ist über einen Widerstand R2 mit dem Ausgang eines Inverters I1 verbunden. Der andere Anschluß der Sekundärseite ist mit dem Eingang eines Inverters I2 verbunden. Der Eingang des Inverters I1 ist mit dem Ausgang des Inverters I2 verbunden und bildet den Ausgang eines durch diese Schaltungsanordnung gestaltetes Speicher-Flip-Flop 80, das zur Zwischenspeicherung der durch den Transformator TR1 eingehenden Eingangssignale dient.

Die Leistungstreiberstufe 20 ist zweistufig aufgebaut. Eine erste Stufe besteht aus sieben parallel geschalteten CMOS-Invertern I3 - I9, deren Eingänge mit dem Ausgang des Speicher-Flip-Flop 92 verbunden sind. Dabei ist die Anzahl der Inverter dieser ersten Stufe nicht kritisch. Es könnten auch mehr oder weniger sein. Es ist lediglich notwendig, daß sie genügend Ausgangsleistung bei hinreichender Flankensteilheit zur Ansteuerung der nachfolgenden zweiten Stufe liefern. Diese zweite Stufe ist aus zwei Treibertransistoren T3, T4 gebildet, die als komplementärer Emitterfolger verschaltet sind. Die Verbindungsleitung zwischen den beiden Emitteranschlüssen ist der Anschluß G für den Gate-Anschluß der Leistungsendstufe.

Die Unterspannungserkennungsstufe 50 wird durch zwei hintereinander geschaltete Inverter I10, I11 gebildet, wobei der Ausgang des Inverters I11 durch einen Widerstand R10 an den Eingang des Inverters I10 zurückgekoppelt ist. Am Eingang des Inverters I10 ist über einen Serienwiderstand R12 ein Spannungsteilernetzwerk angeordnet, das aus einer mit der positiven Betriebsspannung verbundenen Widerstand R11 und einer Parallelschaltung aus einer in SperrRichtung geschalteten Zenerdiode D11 mit einem Kondensator C14 gebildet ist, die mit der negativen Betriebsspannung verbunden sind. Zwischen der positiven Betriebsspannung und der negativen Betriebsspannung ist ein Elektrolykondensator C13 verschaltet.

Durch den Rückkopplungswiderstand R10 arbeitet die Inverterserienschaltung I10, I11 im linearen Bereich. Wenn die Spannung an der Zenerdiode D11 sich der Zenerspannung nähert, d.h. wenn das Spannungverhältnis der Spannung zwischen positiver und negativer Betriebspannung und der durch den Widerstand R11 festgelegten Teilungsspannung sich der Zenerspannung nähert, weil die positive und/oder die negative Betriebspannung absinkt, ändert sich das Eingangspotential am Eingang des Inverters I10, so daß der Umschaltpunkt der Inverter I10, I11 erreicht wird. Wegen des Rückkopplungswiderstandes R10 steigt dabei die Stromaufnahme der Inverter I10, I11 an, so daß die Stromversorgung zusätzlich (mit etwa 35 mA) belastet wird. Sollte diese einen Defekt aufweisen, so sinkt die Betriebsspannung noch weiter ab, so daß die Inverter I10, I11 ihren Umschaltpunkt in jedem Fall durchschreiten. Dann wird das Sperrsignal an die Zwischenspeicherstufe 80 weitergegeben und die Stromaufnahme der Inverter I10, I11 sinkt wieder (auf etwa 1 mA) ab.

Der Ausgang des Inverters I11 speist die Basis eines Transistors T6, dessen Kollektor mit der positiven Betriebsspannung verbunden ist, und dessen Emitter mit einer Verknüpfungsschaltung 120 verbunden ist, die die Sperrsignale für die Zwischenspeicherstufe 80 zusammenfaßt.

Der Eingang der Verknüpfungsschaltung 120 ist Widerstand R9, der zusammen mit einem in Serie geschalteten Widerstand R8 einen Spannungsteiler gegen die negative Betriebsspannung bildet. Am Verbindungspunkt der Widerstände R8, R9 ist die Basis eines Transistors T5 angeschlossen, dessen Emitter mit der negativen Betriebsspannung verbunden ist und dessen Kollektor mit der Kathode einer Diode D8 verbunden ist. Die Anode der Diode D8 ist mit dem Eingang des Inverters I2 der Speicherstufe 40 verbunden.

Die Überstromerkennungsstufe 60 wird durch einen Inverter I13 gebildet, dessen Eingangsanschluß über einen aus zwei Widerständen R14, R15 gebildeten Spannungsteiler mit den Kathoden zweier Dioden D12, D13 verbunden ist. Weiterhin sind die Kathoden der Dioden D12, D13 über einen Widerstand R13 mit der positiven und über einen Kondensator C16 mit der negativen Betriebsspannung verbunden. Die Anode der Diode D13 ist der Sensoranschluß für die DrainSourcespannung der Leistungsendstufe, während die Anode der Diode D13 die Gatespannung bzw. die Ausgangsspannung der Emitter der Transistoren T3, T4 erfaßt.

Sobald die Drain-Source-Spannung der Leistungsendstufe einen vorbestimmten Wert überschreitet schaltet der Inverter I13 um und sperrt über eine Diode D7 das Speicherelement 92 der Eingangsstufe.

Das RC-Netzwerk R13-C16 bewirkt eine Ansprechverzögerung der Überstromerkennungsstufe und ist so bemessen, daß die Leistungsendstufe vollständig durchschalten kann bevor das Speicherelement 92 gesperrt werden kann und keine weiteren Ansteuersignale mehr weiterleitet. Dazu ist das RC-Netzwerk R13-C16 so bemessen, daß es eine Ansprechverzögerung von ca. 100 ns hervorruft.

Die Wiederhol-Impulsunterdrückungsstufe 70 ist durch zwei hintereinander geschaltete Monoflops M1, M2 gebildet, wobei der Eingang des ersten Monoflops M1 ebenfalls mit dem Ausgang der Überstromerkennungsstufe 60 verbunden ist. Die Zeitkonstante des ersten Monoflops M1 wird durch ein RC-Glied R6-C10 bestimmt. Der Ausgang des ersten Monoflops M1 ist mit dem Eingang des zweiten Monoflops M2 verbunden und ist über eine Diode D9 mit der Verknüpfungsschaltung 120 verbunden, die die Sperrsignale für die Zwischenspeicherstufe 80 zusammenfaßt. Die Zeitkonstante des zweiten Monoflops M2 wird durch ein RC-Glied R7-C11 bestimmt. Der Ausgang des zweiten Monoflops M2 ist über eine Diode D10 mit der Verknüpfungsschaltung 120 verbunden.

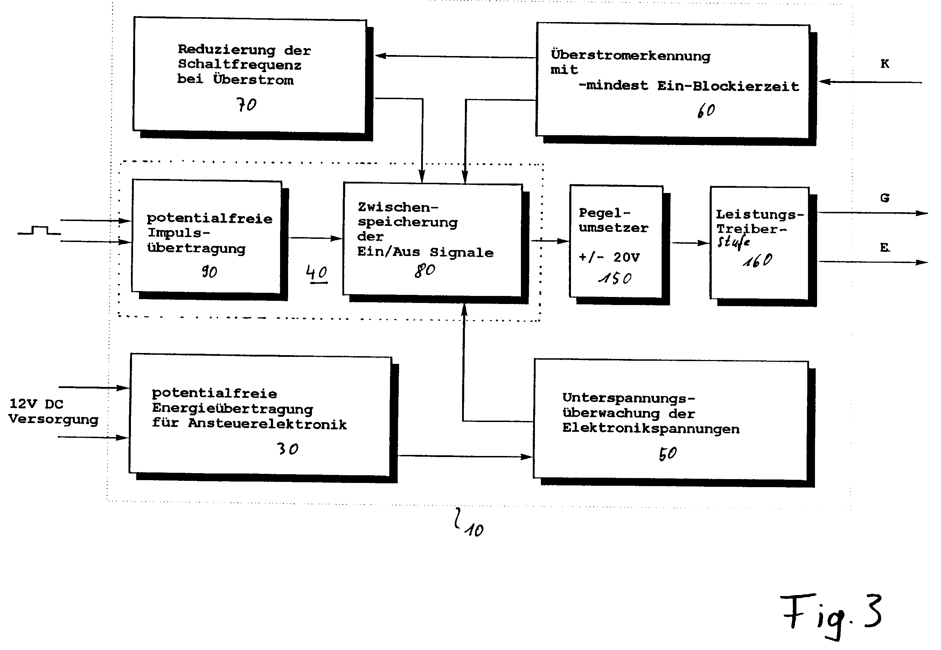

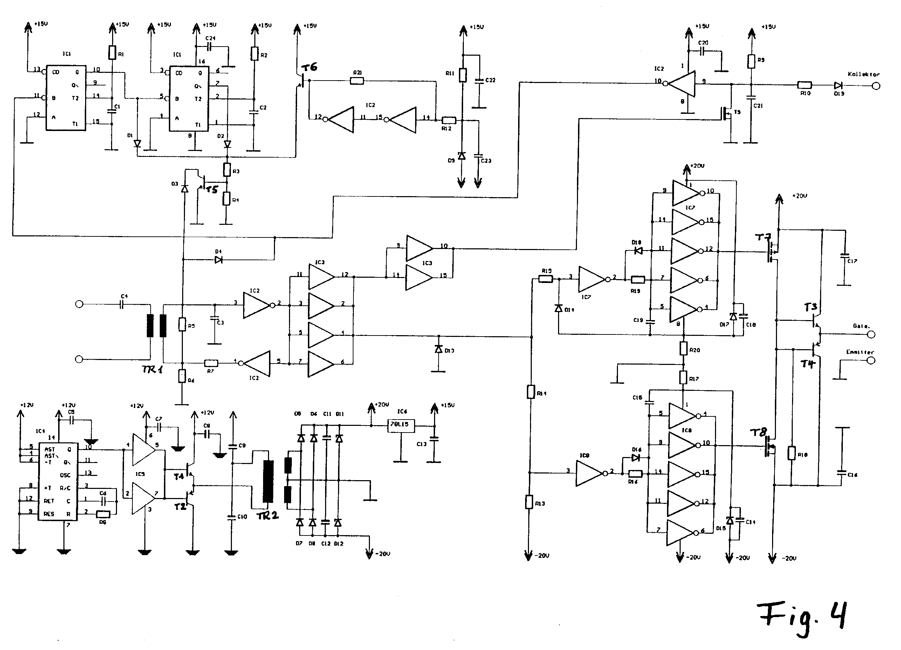

Die in den Fig. 3 und 4 gezeigte Ausführungsform der Treiberschaltung unterscheidet sich von der in den Fig. 1 und 2 gezeigten dadurch, daß sie für eine Leistungsendstufe dient, die aus IGBT-Transistoren gebildet ist. Um eine derartige Leistungsendstufe anzusteuern, ist es erforderlich, die Ansteuersignale auf einen Pegelhub von etwa +/- 20 Volt zu bringen. Dazu dient der Pegelwandler 150 in Fig. 3, der von der Zwischenspeicherstufe 80 gespeist wird. An den Pegelwandler 150 schließt sich dann eine entsprechend gestaltete Leistungstreiberstufe 160 an.

Im übrigen entsprechen sich die Treiberschaltungen der Fig. 1 und 3. Lediglich in einzelnen Details finden sich schaltungstechnische Unterschiede zwischen den Schaltungen der Fig. 2 und 4.

Um für die Ansteuerung der Leistungsendstufe mit IGBT's einen Spannungshub von +/- 20 Volt zur Verfügung zu haben, ist das Ausgangssignal des Speicherelements 92 auf zwei getrennte Treiberstufen aus jeweiligen Serienschaltungen aus Invertern IC7, IC8 geführt, wobei die Treiberstufe aus dem IC7 an einem Betriebsspannungspotential von Masse bis + 20 Volt und die Treiberstufe aus dem IC8 an einem Betriebsspannungspotential von Masse bis - 20 Volt betrieben wird. Die Betriebsspannung für die beiden IC7, IC8 wird jeweils durch eine Zenerdiode D17, D15 stabilisiert, denen jeweils ein Elektrolytkondensator C18, C14 parallelgeschaltet ist.

Um eine Anpassung des Pegels des Ausgangssignals des Speicherelementes 92 zu erreichen, ist das Ausgangssignal auf einen Spannungsteiler aus den Widerständen R13, R14, R15 geführt, wobei das Ausgangssignal des Speicherelements 92 zwischen den Widerstand R14 und R15 eingespeist wird. Der andere Anschluß des Widerstandes R15 führt zu einem Inverter von IC7, dessen Ausgang über ein Verzögerungsglied aus dem Widerstand R19, der dazu parallelgeschalteten Diode D18 und einem mit Masse verbundenen Kondensator C19 mit den Eingängen einer Parallelschaltung aus den restlichen fünf Invertern des IC7 verbunden ist.

In entsprechender Weise ist der Verbindungspunkt zwischen den Widerständen R13 und R14 mit einem Inverter von IC8 verbunden, dessen Ausgang über ein Verzögerungsglied aus dem Widerstand R16, der dazu parallelgeschalteten Diode D16 und einem mit Masse verbundenen Kondensator C15 mit den Eingängen einer Parallelschaltung aus den restlichen fünf Invertern des IC8 verbunden ist.

Die Ausgänge der jeweils parallelgeschalteten Inverter von IC7 und IC8 führen jeweils auf den Gateanschluß eines N-Kanal MOSFET bzw. eines P-Kanal MOSFET T6, T5. Die beiden MOSFETs T5, T6 sind als Halbbrücke verschaltet und dienen zur Ansteuerung einer Gegenstaktendstufe aus zwei bipolaren Transistoren T7, T8, die wie bei der Anordnung nach Fig. 2 miteinander verschaltet sind. Die Verzögerungsglieder haben jeweils eine Zeitkonstante von etwa 20 ns und dienen dazu, einen Brückenschluß der Halbbrücke aus den beiden MOSFETs T5, T6 zu vermeiden.

In den Fig. 5 bis 8 sind die Übertrager für die Ansteuersignale bzw. die Stromversorgung im Detail veranschaulicht. Die Abschirmung der Ferrit-Ringkerntransformatoren erfolgt in beiden Fällen durch eine auf den Ferritring aufgebrachten metallischen Überzug M, der so bemessen ist, daß die jeweiligen Windungen N der Übertrager gegen den Ferritring abgeschirmt sind. Um einen Kurzschluß zu vermeiden, ist der Überzug jeweils radial geschlitzt, so daß keine Kurzschlußwindung entsteht.

Die Abschirmungen M sind jeweils mit dem Masse- oder Erdeanschluß innerhalb ihrer jeweiligen Schaltkreise verbunden.

## Patentansprüche

1. Treiberschaltung (10) für eine MOSFET- oder IGBT-Leistungsendstufe, mit
- einer die Leistungsendstufe ansteuernden Leistungstreiberstufe (20);
- einer die Leistungstreiberstufe (20) ansteuernden, eine Eingangsstufe (90) aufweisende Ansteuerschaltung (40); und
- einer Stromversorgungsstufe (30);
- einer ersten Einrichtung (TR1) in der Eingangsstufe (90) zum potentialgetrennten Einkoppeln von Eingangssignalen,
- einer zweiten Einrichtung (TR2)in der Stromversorgungstufe (30) zum potentialgetrennten Einkoppeln elektrischer Leistung,
- einer Überstromerkennungsstufe (60), die eine Ansteuerung der Leistungstreiberstufe (20) verhindert, indem sie ein Sperrsignal zum Unwirksamschalten der Ansteuerschaltung (40) abgibt, wenn die Drain-source - bzw. die Kollektorspannung der Leistungsendstufe einen vorbestimmten Wert überschreitet, und
- eine Wiederhol-Impulsunterdrückungsstufe (70), die eine Aufhebung des durch das Sperrsignal der Überstromerkennungsstufe (60) hervorgerufenen Unwirksamschaltens der Ansteuerschaltung (40) verhindert,
dadurch gekennzeichnet, daß
der einzige Signaleingang der Wiederhol-Impulsunterdrückungsstufe(70) leitend mit dem Ausgang der Überstromerkennungsstufe (60) verbunden ist.

2. Treiberschaltung nach Anspruch 1, gekennzeichnet durch eine Unterspannungserkennungsstufe (50), die eine Ansteuerung der Leistungstreiberstufe (20) verhindert, wenn eine von der Stromversorgungsstufe (30) abgegebene Betriebsspannung einen vorbestimmten Wert unterschreitet.

3. Treiberschaltung nach Anspruch 1, dadurch gekennzeichnet, daß die erste Einrichtung (TR1) der Eingangsstufe (90) einen hochfrequenzsignalübertragenden Transformator für die Einspeisung von Ansteuersignalen aufweist.

4. Treiberschaltung nach einen der vorhergehenden Ansprüche, dadurch gekennzeichnet, daß die Ansteuerschaltung (40) ein Speicherelement (80) zur Speicherung der Ansteuersignale aufweist.

5. Treiberschaltung nach dem vorhergehenden Anspruch, dadurch gekennzeichnet, daß das Speicherelement (80) ein aus zwei Invertern (I1, I2,) gebildetes Flip-Flop aufweist.

6. Treiberschaltung nach Anspruch 1, dadurch gekennzeichnet, daß die zweite Einrichtung (TR2) der Stromversorgungsstufe (30) einen Transformator für die Übertragung von hochfrequenter elektrischer Leistung aufweist.

7. Treiberschaltung nach dem vorhergehenden Anspruch, dadurch gekennzeichnet, daß der Transformator (TR2) ein elektrisches Leistungssignal mit einer Frequenz im Bereich von 0,5 MHz bis 5 MHz, vorzugsweise 1,5 MHz überträgt.

8. Treiberschaltung nach dem vorhergehenden Anspruch, dadurch gekennzeichnet, daß das elektrische Leistungssignal ein Rechteck-Impulszug ist, der von einer durch einen Oszillator (IC2) gespeisten Verstärkerstufe (T1, T2) dem Transformator zugeführt ist.

9. Treiberschaltung nach einem der Ansprüche 3 oder 6, dadurch gekennzeichnet, daß der erste Transformator (TR1) und/oder der zweite Transformator (TR2) eine primärseitige und/oder eine sekundärseitige Abschirmung (M) aufweisen.

10. Treiberschaltung nach Anspruch 1, dadurch gekennzeichnet, daß die Stromversorgungsstufe (30) eine positive und eine negative Betriebsspannung bereitstellt.

11. Treiberschaltung nach Anspruch 2, dadurch gekennzeichnet, daß die Unterspannungserkennungsstufe (50) einen Komparator (I10, I11) aufweist, der eine einstellbare Hysteresekurve hat.

12. Treiberschaltung nach dem vorhergehenden Anspruch, dadurch gekennzeichnet, daß der Komparator (I10, I11) aus zwei in Reihe geschalteten rückgekoppelten Invertern gebildet ist, an deren Eingang eine Z-Diode (D11) angekoppelt ist.

13. Treiberschaltung nach Anspruch 2, dadurch gekennzeichnet, daß die Unterspannungserkennungsstufe (50) ein Signal zum Unwirksamschalten der Ansteuerschaltung (40) abgibt, wenn eine von der Stromversorgungsstufe (30) abgegebene Betriebsspannung einen vorbestimmten Wert unterschreitet.

14. Treiberschaltung nach Anspruch 1, dadurch gekennzeichnet, daß ein Inverter (I13) das Sperrsignal an das Speicherelement (80) der Ansteuerschaltung (40) abgibt.

15. Treiberschaltung nach dem vorhergehenden Anspruch, dadurch gekennzeichnet, daß der Inverter (I13) an seinem Eingang ein Re-Netzwerk (R13, C16) aufweist, das eine Ansprechverzögerung der Überstromerkennungsstufe (60) bewirkt, und so bemessen ist, daß die Leistungsendstufe vollständig durchschalten kann.

16. Treiberschaltung nach dem vorhergehenden Anspruch, dadurch gekennzeichnet, daß mit dem RC-Netzwerk (R13, C16) und dem Inverter (I13) Mindest-Ein-Zeiten von weniger als 100 ns erzielt werden.

17. Treiberschaltung nach Anspruch 1, dadurch gekennzeichnet, daß die Leistungstreiberstufe (20) mehrere parallelgeschaltete Inverter (I3 .. I9) aufweist, deren Ausgänge mit zwei Treibertransistoren (T3, T4) verbunden sind, die die zur Ansteuerung des Eingangs-Anschlusses (G) der Leistungsendstufe erforderlichen Signale bereitstellen.

18. Treiberschaltung nach dem vorhergehenden Anspruch, dadurch gekennzeichnet, daß die Leistungstreiberstufe (20) eine Pegelumsetzerstufe (150) und wenigstens zwei separate Inverter (IC7,IC8) aufweist, die auf unterschiedlichem Betriebsspannungsniveau arbeiten, deren Ausgänge mit einer Treibertransistorstufe (T3,T4; T7,T8) verbunden ist, die die zur Ansteuerung des Eingangsanschlusses (G) der Leistungsendstufe erforderlichen Signale bereitstellt.

19. Treiberschaltung nach dem vorhergehenden Anspruch, dadurch gekennzeichnet, daß die Treibertransistorstufe eine aus einem P-Kanal-MOSFET und einem N-Kanal-MOSFET gebildete Halbbrücke (T7, T8) aufweist, und die Leistungstreiberstufe wenigstens ein Totzeitglied (R19, C19; R16, C15) für das Ansteuersignal aufweist.

## Claims

1. A driver circuit (10) for a MOSFET or IGBT power output stage, comprising
- a power driver stage (20) activating the power output stage;
- a trigger circuit (40) having an input stage (90) and activating the power driver stage (20); and
- a power supply stage (30);
- a first means (TR1) in the input stage (90) for the potential-separated feeding of input signals,
- a second means (TR2) in the power supply stage (30) for the potential-separated feeding of electrical power,
- a high current detection stage (60) which prevents an activation of the power driver stage (20) by emitting an inhibiting signal for disabling the trigger circuit (40) when the drain source voltage, or the collector voltage of the power output stage, exceeds a predetermined value, and
- a repeat pulse inhibiting stage (70) which prevents a cancellation of disabling the trigger circuit (40) caused by the inhibiting signal of the high current detection stage (60),
characterised in that
the only signal input of the repeat pulse inhibiting stage (70) is conductively connected with the output of the high current detection stage (60).

2. The driver circuit as defined in claim 1, characterised by a low voltage detection stage (50) which prevents an activation of the power driver stage (20) when an operating voltage supplied by the power supply stage (30) falls below a predetermined value.

3. The driver circuit as defined in claim 1, characterised in that the first means (TR1) of the input stage (90) includes a high-frequency signal transmitting transformer for feeding activation signals.

4. The driver circuit as defined in one of the preceding claims, characterised in that the trigger circuit (40) includes a memory element (80) for storing the activation signals.

5. The driver circuit as defined in the preceding claim, characterised in that the memory element (80) includes a flip-flop formed of two inverters (I1, I2).

6. The driver circuit as defined in claim 1, characterised in that the second means (TR2) of the power supply stage (30) includes a transformer for transmitting high-frequency electrical power.

7. The driver circuit as defined in the preceding claim, characterised in that the transformer (TR2) transmits an electrical power signal having a frequency in the range of from 0.5 MHz to 5 MHz, Preferably 1.5 MHz.

8. The driver circuit as defined in the preceding claim, characterised in that the electrical power signal is a square wave pulse train which is fed to the transformer by an amplifying stage (T1, T2) energised by an oscillator (IC2).

9. The driver circuit as defined in claim 3 or 6, characterised in that the first transformer (TR1) and/or the second transformer (TR2) have/has a primary side and/or a secondary side shield (M) each.

10. The driver circuit as defined in claim 1, characterised in that the power supply stage (30) provides for positive and negative operating voltages.

11. The driver circuit as defined in claim 2, characterised in that the low voltage detection state (50) includes a comparator (I10, I11) having an adjustable hysteresis curve.

12. The driver circuit as defined in the preceding claim, characterised in that the comparator (I10, I11) is formed of two serially connected, looped-back inverters, to the input of which a Z-diode (D11) is coupled.

13. The driver circuit as defined in claim 2, characterised in that the low voltage detection stage (50) emits a signal for disabling the trigger circuit (40) when an operating voltage supplied by the power supply stage (30) falls below a predetermined value.

14. The driver circuit as defined in claim 1, characterised in that an inverter (I13) feeds the inhibiting signal to the memory element (80) of the trigger circuit (40).

15. The driver circuit as defined in the preceding claim, characterised in that the inverter (I13) comprises an PC network (R13, C16) at its input which causes a response delay of the high current detection stage (60) and is dimensioned such that the power output stage can become entirely conductive.

16. The driver circuit as defined in the Preceding claim, characterised in that minimum on-times of less than 100 ns are achieved with the RC network (R13, C16) and the inverter (I13).

17. The driver circuit as defined in claim 1, characterised in that the power driver stage (20) includes several parallelly connected inverters (I3 .. I9) the outputs of which are connected to two driver transistors (T3, T4) providing the signals required to activate the input terminal (G) of the power output stage.

18. The driver circuit as defined in the Preceding claim, characterised in that the power driver stage (20) includes a level converter stage (150) and at least two separate inverters (IC7, IC8) operating at different operational voltage levels, the outputs of which are connected to a driver transistor stage (T3, T4; T7, T8) which provides the signals required to activate the input terminal (G) of the power output stage.

19. The driver circuit as defined in the preceding claim, characterised in that the driver transistor stage has a half-bridge (T7, T8) formed of a P-channel-MOSFET and an N-channel-MOSFET, and the power drive stage includes at least one dead time circuit (R19, C19; R16, C15) for the activation signal.

## Revendications

1. Circuit d'attaque (10) pour un étage de puissance à transistor MOS ou à transistor bipolaire à grille isolée comprenant
- un étage d'attaque de puissance (20) excitant l'étage de puissance;
- un circuit d'excitation (40) excitant l'étage d'attaque de puissance (20) présentant un étage d'entrée (90); et
- un étage d'alimentation électrique (30);
- un premier moyen (TR1) dans l'étage d'entrée (90) pour l'injection à séparation de potentiels de signaux d'entrée,
- un deuxième moyen (TR2) dans l'étage d'alimentation électrique (30) pour l'injection à séparation de potentiels de puissance électrique,
- un étage de détection de surintensité (60) qui empêche une excitation de l'étage d'attaque de puissance (20) en délivrant un signal inhibiteur pour l'inactivation du circuit d'excitation (40) lorsque la tension drain-source, respectivement la tension de collecteur de l'étage de puissance dépasse une valeur prédéterminée, et
- un étage de répétition d'atténuation d'impulsion (70) qui empêche une neutralisation de l'inactivation du circuit d'excitation (40) provoquée par le signal inhibiteur de l'étage de détection de surintensité (60),
caractérisé en ce que
la seule entrée de signaux de l'étage de répétition d'atténuation d'impulsion (70) a une liaison conductrice avec la sortie de l'étage de détection de surintensité (60).

2. Circuit d'attaque selon la revendication 1, caractérisé par un étage de détection de sous-tension (50) qui empêche une excitation de l'étage d'attaque de puissance (20) lorsqu'une tension de service délivrée par l'étage d'alimentation électrique (30) passe en dessous d'une valeur prédéterminée.

3. Circuit d'attaque selon la revendication 1, caractérisé en ce que le premier moyen (TR1) de l'étage d'entrée (90) présente un transformateur de transmission de signaux à haute fréquence pour l'alimentation en signaux d'excitation.

4. Circuit d'attaque selon l'une quelconque des revendications précédentes, caractérisé en ce que le circuit d'excitation (40) présente un élément de stockage (80) pour le stockage des signaux d'excitation.

5. Circuit d'attaque selon la revendication précédente, caractérisé en ce que l'élément de stockage (80) est une bascule formée de deux circuits inverseurs (I1, I2).

6. Circuit d'attaque selon la revendication 1, caractérisé en ce que le deuxième moyen (TR2) de l'étage d'alimentation électrique (30) présente un transformateur pour la transmission d'une puissance électrique à haute fréquence.

7. Circuit d'attaque selon la revendication précédente, caractérisé en ce que le transformateur (TR2) transmet un signal de puissance électrique ayant une fréquence située dans la plage de 0,5 MHz à 5 MHz, de préférence de 1,5 MHz.

8. Circuit d'attaque selon la revendication précédente, caractérisé en ce que le signal de puissance électrique est un train d'impulsions rectangulaires qui est transmis au transformateur par un étage d'amplification (T1, T2) alimenté par un oscillateur (IC2).

9. Circuit d'attaque selon l'une quelconque des revendications 3 ou 6, caractérisé en ce que le premier transformateur (TR1) et / ou le deuxième transformateur (TR2) présentent un blindage (M) du côté primaire et / ou du côté secondaire.

10. Circuit d'attaque selon la revendication 1, caractérisé en ce que l'étage d'alimentation électrique (30) fournit une tension de service positive et une tension de service négative.

11. Circuit d'attaque selon la revendication 2, caractérisé en ce que l'étage de détection de sous-tension (50) présente un comparateur (I10, I11) qui possède une courbe d'hystérésis réglable.

12. Circuit d'attaque selon la revendication précédente, caractérisé en ce que le comparateur (I10, I11) est formé de deux circuits inverseurs couplés rétroactivement en série à l'entrée desquels est couplée une diode de Zener (D11).

13. Circuit d'attaque selon la revendication 2, caractérisé en ce que l'étage de détection de sous-tension (50) délivre un signal servant à l'inactivation du circuit d'excitation (40) lorsqu'une tension de service délivrée par l'étage d'alimentation électrique (30) passe en dessous d'une valeur prédéterminée.

14. Circuit d'attaque selon la revendication 1, caractérisé en ce qu'un circuit inverseur (I13) délivre le signal inhibiteur à l'élément de stockage (80) du circuit d'excitation (40).

15. Circuit d'attaque selon la revendication précédente, caractérisé en ce que le circuit inverseur (I13) présente à son entrée un réseau RC (R13, C16) qui réalise une durée de fermeture de l'étage de détection de surintensité (60) et est conçu de telle façon que l'étage de puissance puisse interconnecter totalement.

16. Circuit d'attaque selon la revendication précédente, caractérisé en ce qu'on peut obtenir avec le réseau RC (R13, C16) et le circuit inverseur (I13) des durées en service minimums intérieures à 100 ns.

17. Circuit d'attaque selon la revendication 1, caractérisé en ce que l'étage d'attaque de puissance (20) présente plusieurs circuits inverseurs (I3 .. I9) montés en parallèle dont les sorties sont reliées à deux transistors d'attaque (T3, T4) qui fournissent les signaux nécessaires à l'excitation de la connexion d'entrée (G) de l'étage de puissance.

18. Circuit d'attaque selon la revendication précédente, caractérisé en ce que l'étage d'attaque de puissance (20) présente un étage de conversion de niveau (150) et au moins deux circuits inverseurs séparés (IC7, IC8) qui travaillent à différents niveaux de tension de service, dont les sorties sont reliées à un étage de transistors d'attaque (T3, T4; T7, T8) qui fournit les signaux nécessaires pour l'excitation de la connexion d'entrée (G) de l'étage de puissance.

19. Circuit d'attaque selon la revendication précédente, caractérisé en ce que l'étage de transistors d'attaque présente un demi-pont (T7, T8) formé d'un transistor MOS à canal de type P et d'un transistor MOS à canal de type N et en ce que l'étage d'attaque de puissance présente au moins un élément de temps mort (R19, C19; R16, C15) pour le signal d'excitation.
